# EUROPÄISCHE PATENTSCHRIFT

(11) **EP 2 622 950 B1**
(45) Veröffentlichungstag und Bekanntmachung des Hinweises auf die Patenterteilung: **22.02.2017**
(21) Anmeldenummer: 11757623.1
(22) Anmeldetag: 16.09.2011
(51) Int. Cl.: G01H 17/00, H05K 5/00, B60R 16/023

(54) **STEUERGERÄT**
CONTROL DEVICE
APPAREIL DE COMMANDE

(30) Priorität: 28.09.2010 DE 102010041540
(43) Veröffentlichungstag der Anmeldung: 07.08.2013
(73) Patentinhaber: Robert Bosch GmbH, 70442 Stuttgart (DE)
(72) Erfinder: LUHR, Volker, 71706 Markgroeningen (DE); FAAS, Matthias, 71720 Oberstenfeld (DE); FERIDOUNI, Hamed, 70173 Stuttgart (DE)
(86) Internationale Anmeldenummer: PCT/EP2011/066091
(87) Internationale Veröffentlichungsnummer: WO 2012/052233

(56) Entgegenhaltungen:
- EP-A2- 1 341 263
- WO-A1-93/13963
- DE-A1- 19 755 767
- DE-A1-102006 006 078

## Beschreibung

### Stand der Technik

Die vorliegende Erfindung betrifft ein Steuergerät, insbesondere ein Steuergerät mit einem Sensor, das bei Kraftfahrzeugen eingesetzt wird.

Steuergeräte des Standes der Technik sind im Wesentlichen aus einer Leiterplatte mit einem Steckerelement aufgebaut, die in einem Gehäuse fixiert ist. Ein derartiges Steuergerät ist aus der DE 10 2006 006 078 B4 bekannt, bei der das Steckerelement samt Leiterplatte mit dem Gehäuse verrastet ist. Die DE 42 32 048 C2 offenbart ein Steuergerät, dessen Steckerelement samt Leiterplatte zwischen zwei Gehäuseteilen eingeklemmt ist. DE 197 55 767 A1 zeigt ein Gehäuse mit einer Steckereinheit nach dem Oberbegriff des Anspruchs 1, in welcher die Steckereinheit nachträglich am Gehäuse montiert und durch einen Formschluss zwischen dem Gehäuse und der Steckereinheit durch eine bekannte Schnapp-/Rastverbindung gegen ein unerwünschtes Lösen der Steckverbindung fixiert wird. DE 10 2006 006 078 A1 zeigt eine elektronische Steuerungseinheit, bei welcher eine Anschlusseinheit ein im Wesentlichen keilförmig ausgebildetes Klemmelement aufweist, welches in korrespondierende Querschnitte innerhalb des Gehäuses eingreift, um die an der Anschlusseinheit angeordnete Leiterplatte in dem Gehäuse festzuklemmen. Aufgrund der Toleranzmaße im verbauten Zustand können das Steckerelement und das Gehäuse hierbei durch Vibrationen während des Betriebs aneinanderstoßen bzw. klappern, wodurch die Funktion des Steuergeräts gestört wird.

### Offenbarung der Erfindung

Das erfindungsgemäße Steuergerät mit den Merkmalen des Anspruchs 1 weist demgegenüber den Vorteil auf, dass das Steckerelement mit einem Gehäuseteil mittels einer mechanischen Verbindung fest verbunden ist, die ein Aneinanderstoßen bzw. Klappern benachbarter Bauteile und daraus resultierende Funktionsstörungen des Steuergeräts verhindert. Dies wird erfindungsgemäß dadurch erreicht, dass die mechanische Verbindung zwischen dem Gehäuseteil und dem Steckerelement ein vorstehendes Element und ein Aufnahmeelement mit einer Ausnehmung zur Aufnahme des vorstehenden Elements aufweist. Hierbei weist die Ausnehmung einen Basisbereich, einen ersten Wandbereich und einen zweiten Wandbereich auf, wobei am ersten Wandbereich eine erste Rippe und am zweiten Wandbereich eine zweite Rippe angeordnet ist. Dies ermöglicht eine dauerhaft stabile, vibrationsresistente und einfach zu montierende Befestigung des Steckerelements am Gehäuseteil, sowie eine zeit- und kosteneffiziente Fertigung des gesamten Steuergeräts. Ferner ist hierdurch möglich, einen schwingungsempfindlichen Sensor in das Steuergerät zu integrieren, bei dem keine Gefahr einer Fehlfunktion durch Vibrationen o. ä. des Gehäuses und/oder des Steckerelementes gegeben ist.

Die Unteransprüche zeigen bevorzugte Weiterbildungen der Erfindung.

Gemäß einer bevorzugten Ausgestaltung der Erfindung ist wenigstens einer der Wandbereiche durch einen Schenkel gebildet und an einer Außenseite des Schenkels ist ein Schlitz angeordnet. Durch diese Formgebung wird eine elastische Verformung des Schenkels beim Einfügen des Steckerelements in das Gehäuseteil ohne großen Kraftaufwand ermöglicht. Somit wird zusätzlich eine kraftschlüssige Befestigung aufgrund der Federfunktion des Schenkels bereitgestellt, die einen permanenten Kontakt mit sehr hoher Dauerhaltbarkeit bei jeder Toleranzlage sicherstellt. Ferner kann die Leiterplatte samt Steckerelement mit den Gehäuseteilen auf einfache Weise verbunden werden, ohne Spannungen zwischen Kontakten des Steckerelements und der Leiterplatte zu erzeugen.

Weiterhin bevorzugt ist die erste Rippe in Längsrichtung der Ausnehmung versetzt zur zweiten Rippe angeordnet. Weiterhin bevorzugt weisen die Rippen ein schneidenförmiges Ende auf. Durch die versetzte und linienförmig ausgebildete Berührung wird eine verbesserte Führung sowie Kraftverteilung zwischen dem vorstehenden Element und dem Aufnahmeelement gewährleistet. Ferner wird dadurch ein gegenseitiges Verdrehen bzw. Verkippen der Bauteile in der mechanischen Befestigung bei der Montage verhindert.

In weiterer vorteilhafter Ausgestaltung der Erfindung ist der Sensor ein Drehraten-Sensor und/oder ein Beschleunigungssensor zur Erfassung der Drehrate und/oder der Beschleunigung des Fahrzeugs in einer oder mehreren Achsrichtungen. Durch die formschlüssige und kraftschlüssige mechanische Verbindung zwischen Gehäuse und Steckerelement werden schwingungstechnische Störungen beim Fahrzeugbetrieb zuverlässig unterdrückt und somit eine kontinuierlich betriebssichere Sensorfunktion im Steuergerät gewährleistet.

Vorzugsweise sind an jedem der Wandbereiche jeweils mehrere Rippen parallel zueinander angeordnet. Weiterhin bevorzugt verlaufen die Rippen senkrecht zur Längsrichtung der Ausnehmung. Hierdurch kann eine verbesserte Kraftverteilung in der mechanischen Verbindung mit einer entsprechend der Anzahl der Rippen reduzierten Belastung pro Rippe bereitgestellt werden.

In weiterer vorteilhafter Ausgestaltung der Erfindung sind zwischen dem Steckerelement und dem Gehäuseteil mehrere mechanische Verbindungen vorgesehen. Weiterhin bevorzugt ist jedes der Gehäuseteile mittels einer mechanischen Verbindung mit dem Steckerelement verbunden. Somit wird eine betriebssichere und klapperfreie Fixierung mit permanentem Kontakt zwischen dem Steckerelement und einem oder beiden Gehäuseteilen bereitgestellt, die auch hohen Vibrationsbelastungen im Betrieb des Fahrzeugs standhält.

### Zeichnung

Nachfolgend wird ein Ausführungsbeispiel der Erfindung unter Bezugnahme auf die begleitende Zeichnung im Detail beschrieben. In der Zeichnung ist:
- Figur 1: eine perspektivische Darstellung des erfindungsgemäßen Steuergeräts,
- Figur 2: eine Darstellung der mechanischen Verbindung zwischen Steckerelement und Gehäuseteil des Steuergeräts von Figur 1,
- Figur 3: eine vergrößerte Darstellung der mechanischen Verbindung von Figur 2, und
- Figur 4: eine weitere Darstellung der mechanischen Verbindung.

### Ausführungsform der Erfindung

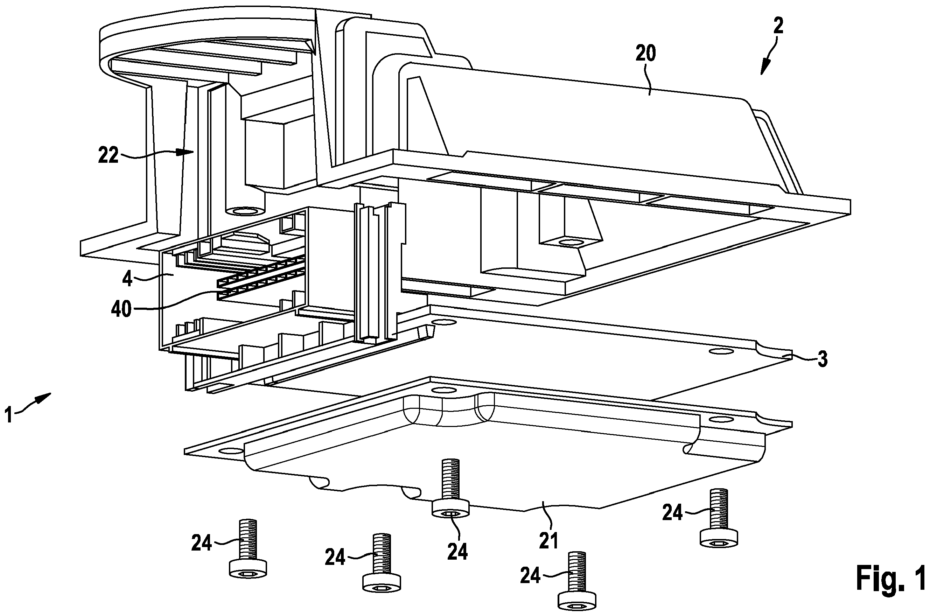

Nachfolgend wird unter Bezugnahme auf Figur 1 bis 4 ein Steuergerät 1 gemäß einem bevorzugten Ausführungsbeispiel der Erfindung im Detail beschrieben.

Figur 1 zeigt eine perspektivische Darstellung eines Steuergeräts 1 gemäß einem bevorzugten Ausführungsbeispiel der Erfindung, bei der die einzelnen Bauteil-Komponenten zur besseren Verdeutlichung auseinandergezogen dargestellt sind. Wie aus Figur 1 ersichtlich, umfasst das Steuergerät 1 ein Gehäuse 2 mit einem ersten Gehäuseteil 20 und einem zweiten Gehäuseteil 21 sowie eine dazwischen angeordnete Leiterplatte 3. Die Leiterplatte 3 ist sowohl mechanisch als auch elektrisch mit einem Steckerelement 4 mit einer Vielzahl von Kontakten 40 verbunden. Die die Leiterplatte 3 und das Steckerelement 4 umfassende Baugruppe ist dann mittels einer mechanischen Verbindung 5 mit einem Gehäuseteil verbunden.

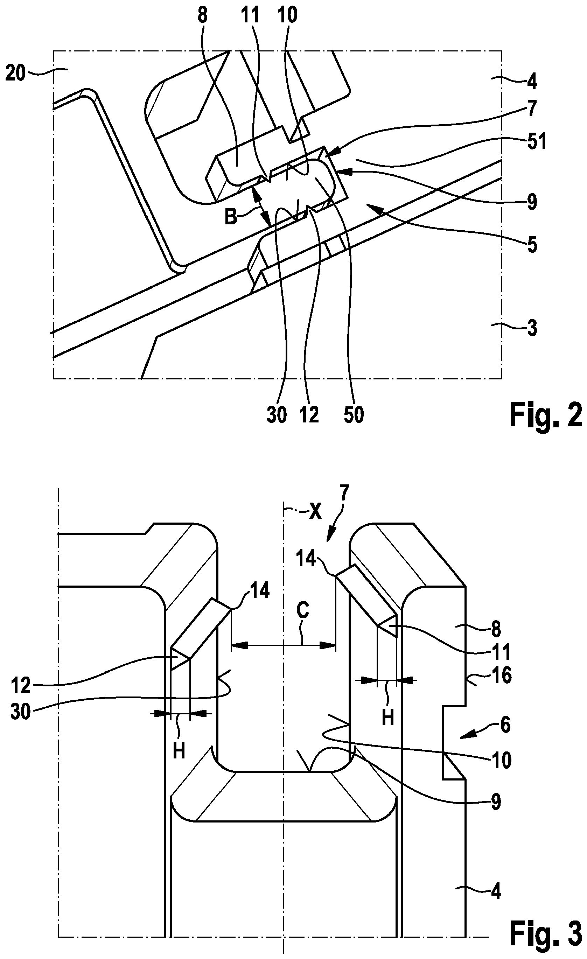

Wie aus der vergrößerten Darstellung von Figur 2 ersichtlich, weist die mechanische Verbindung 5 ein vorstehendes Element 50 mit einer Breite B, das am ersten Gehäuseteil 20 ausgebildet ist, sowie ein am Steckerelement 4 ausgebildetes Aufnahmeelement 51 mit einer Ausnehmung 7 auf. In der Ausnehmung 7 ist das vorstehende Element 50 aufgenommen. Die Ausnehmung 7 weist einen Basisbereich 9, einen ersten Wandbereich 10 und einen zweiten Wandbereich 30 auf. Am ersten Wandbereich 10 der Ausnehmung 7 ist eine vorstehende erste Rippe 11 und am zweiten Wandbereich 30 der Ausnehmung 7 eine vorstehende zweite Rippe 12 angeordnet.

Wie aus Figur 3 ersichtlich, ist die erste Rippe 11 zudem in Längsrichtung X-X der Ausnehmung 7 versetzt zur zweiten Rippe 12 angeordnet. Zudem weisen die ersten und zweiten Rippen 11, 12 jeweils ein schneidenartiges Ende 14 auf. Aufgrund der schneidenartigen Enden 14 der ersten und zweiten Rippen 11,12 wird ein linienförmiger formschlüssiger Kontakt zwischen dem vorstehenden Element 50 und dem Aufnahmeelement 51 bereitgestellt. Alternativ können an jedem Wandbereich 10, 30 der Ausnehmung 7 auch jeweils mehrere Rippen 11, 12 parallel zueinander angeordnet sein. Wie aus Figur 3 weiter ersichtlich, ist der Wandbereich 10 durch einen Schenkel 8 gebildet und an einer Außenseite 16 des Schenkels 8 ist ein Schlitz 6 angeordnet. Durch den Schlitz 6 wird der Querschnitt des Schenkels 8 reduziert, sodass dessen elastische Verformung mit geringer Kraft ermöglicht wird. Hierdurch wird ein federnder Schenkel 8 gebildet.

Die ersten und zweiten Rippen 11, 12 ragen jeweils mit einer Höhe H aus dem ersten Wandbereich 10 bzw. dem zweiten Wandbereich 30 der Ausnehmung 7 heraus. Die Höhen H sind hierbei so bemessen, dass die Breite B (siehe Figur 2) des vorstehenden Elements 50 etwas größer als ein verbleibendes Öffnungsmaß C der Ausnehmung 7 des Aufnahmeelements 51 ausgebildet ist.

Bei der Montage des Steuergeräts 1 wird das Steckerelement 4 samt Leiterplatte 3 zuerst mittels einer Pressvorrichtung in einen Ausschnitt 22 des ersten Gehäuseteils 20 eingefügt und mit diesem mittels der mechanischen Verbindung 5 (siehe Figur 2) verbunden. Nach Entfernen der Pressvorrichtung wird das zweite Gehäuseteil 21 danach auf dem Steckerelement 4 und dem ersten Gehäuseteil 20 positioniert und mittels selbstfurchenden Schrauben 24 mit diesem und dem ersten Gehäuseteil 20 verschraubt. Darüber hinaus ist im Steuergerät 1 ein in der Figur 1 nicht sichtbar dargestellter Drehraten-Sensor und/oder Beschleunigungssensor zur Erfassung der Drehrate und/oder Beschleunigung des Fahrzeugs angeordnet. Obwohl in den Figuren nicht dargestellt, können alternativ zwischen dem Steckerelement 4 und dem Gehäuseteil 20 auch mehrere mechanische Verbindungen 5 vorgesehen werden. Darüber hinaus kann sowohl das erste Gehäuseteil 20 als auch das zweite Gehäuseteil 21 mittels der mechanischen Verbindung 5 mit dem Steckerelement 4 verbunden werden.

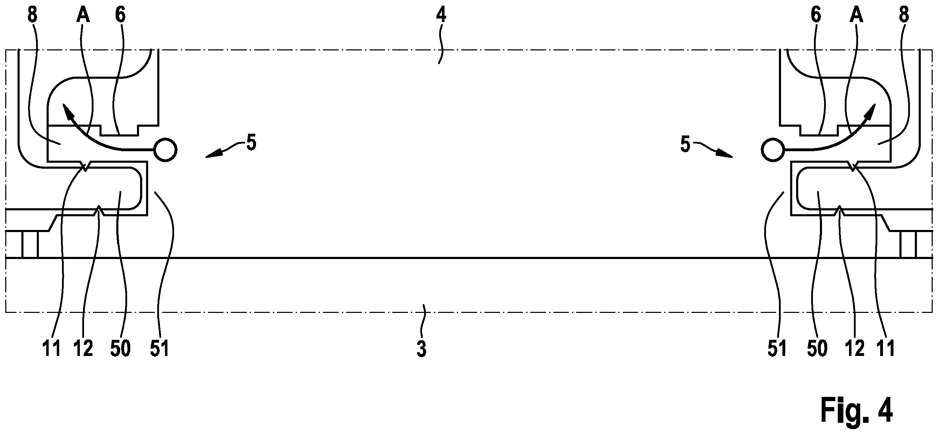

Bei der Montage des Steuergeräts 1 wird beim Einfügen des vorstehenden Elements 50 und des Aufnahmeelements 51 der mechanischen Verbindung 5 mittels der Pressvorrichtung eine definierte Kraft aufgebracht. Durch diese Krafteinwirkung wird der Schenkel 8 des Aufnahmeelements 51, wie in Figur 4 dargestellt, in Richtung eines Pfeils A elastisch bzw. federnd aufgebogen und bewirkt somit neben dem formschlüssigen einen zusätzlichen kraftschlüssigen Kontakt zwischen dem vorstehenden Element 50 und dem Aufnahmeelement 51 der mechanischen Verbindung 5. Alle Toleranzmaße der mechanischen Verbindung 5 sind hierbei so ausgelegt, dass eine dauerhaft stabile, feste Fixierung sichergestellt ist.

Somit wird erfindungsgemäß ein Steuergerät 1, insbesondere zum Einsatz bei Kraftfahrzeugen bereitgestellt, das durch die erfindungsgemäße Ausgestaltung der mechanischen Verbindung 5 einen lebenslang zuverlässigen Kontakt zwischen dem Steckerelement 4 und dem Gehäuse 2 gewährleistet. Dadurch können ein vibrationsbedingtes Klappern aneinanderstoßender Bauteile sowie daraus resultierende Fehlfunktionen oder Störungen, bei Steuergeräten mit integrierten schwingungsempfindlichen Sensoren, vermieden werden.

## Patentansprüche

1. Steuergerät, umfassend:
- ein Gehäuse (2) mit einem ersten Gehäuseteil (20) und einem zweiten Gehäuseteil (21),
- eine im Gehäuse (2) angeordnete Leiterplatte (3),
- ein Steckerelement (4) mit einer Vielzahl von Kontakten (40), welches sowohl mechanisch als auch elektrisch mit der Leiterplatte (3) verbunden ist, und
- einen schwingungsempfindlichen Sensor,
- wobei das Steckerelement (4) mit einem der Gehäuseteile (20, 21) mittels einer mechanischen Verbindung (5) fest verbunden ist,
- wobei die mechanische Verbindung (5) ein vorstehendes Element (50) und ein Aufnahmeelement (51) mit einer Ausnehmung (7) zur Aufnahme des vorstehenden Elements (50) aufweist,
- wobei die Ausnehmung (7) einen Basisbereich (9), einen ersten Wandbereich (10) und einen zweiten Wandbereich (30) aufweist und
- wobei am ersten Wandbereich (10) eine erste Rippe (11) und am zweiten Wandbereich (30) eine zweite Rippe (12) angeordnet ist, wobei die erste Rippe (11) und die zweite Rippe (11) jeweils mit einer Höhe H aus dem ersten Wandbereich (10) bzw. dem zweiten Wandbereich (30) der Ausnehmung (7) herausragen, wobei die Höhe H so bemessen ist, dass eine Breite B des vorstehenden Elements (50) etwas größer als ein verbleibendes Öffnungsmaß C der Ausnehmung (7) des Aufnahmeelements (51) ausgebildet ist, **dadurch gekennzeichnet dass** wenigstens einer der Wandbereiche (10, 30) durch einen Schenkel (8) gebildet ist und an einer Außenseite (16) des Schenkels (8) ein Schlitz (6) angeordnet ist, durch welchen eine elastische Verformung des Schenkels beim Einfügen des Steckerelements in das Gehäuseteil ohne großen Kraftaufwand ermöglicht wird.

2. Steuergerät nach einem der vorstehenden Ansprüche, **dadurch gekennzeichnet, dass** die erste Rippe (11) normal zum Basisbereich (9) der Ausnehmung (7) versetzt zur zweiten Rippe (12) angeordnet ist.

3. Steuergerät nach einem der vorstehenden Ansprüche, **dadurch gekennzeichnet, dass** der Sensor ein Drehraten-Sensor und/oder ein Beschleunigungssensor ist.

4. Steuergerät nach einem der vorhergehenden Ansprüche, **dadurch gekennzeichnet, dass** die Rippen (11, 12) eine schneidenförmige Kante (14) aufweisen.

5. Steuergerät nach einem der vorhergehenden Ansprüche, **dadurch gekennzeichnet, dass** an jedem Wandbereich (10, 30) der Ausnehmung (7) jeweils mehrere Rippen (11, 12) parallel zueinander angeordnet sind.

6. Steuergerät nach einem der vorhergehenden Ansprüche, **dadurch gekennzeichnet, dass** die Rippen (11, 12) parallel zum Basisbereich (9) der Ausnehmung (7) verlaufen.

7. Steuergerät nach einem der vorhergehenden Ansprüche, **dadurch gekennzeichnet, dass** zwischen dem Steckerelement (4) und dem Gehäuseteil (20, 21) mehrere mechanische Verbindungen (5) vorgesehen sind.

8. Steuergerät nach einem der vorstehenden Ansprüche, **dadurch gekennzeichnet**, das jedes der Gehäuseteile (20, 21) mittels einer mechanischen Verbindung (5) mit dem Steckerelement (4) verbunden ist.

## Claims

1. Controller comprising:
- a housing (2) having a first housing part (20) and a second housing part (21),
- a printed circuit board (3) which is arranged in the housing (2),
- a plug element (4) having a large number of contacts (40), which plug element is connected both mechanically and electrically to the printed circuit board (3), and
- a vibration-sensitive sensor,
- wherein the plug element (4) is fixedly connected to one of the housing parts (20, 21) by means of a mechanical connection (5),
- wherein the mechanical connection (5) has a projecting element (50) and a receiving element (51) with a recess (7) for receiving the projecting element (50),
- wherein the recess (7) has a base region (9), a first wall region (10) and a second wall region (30), and
- wherein a first rib (11) is arranged on the first wall region (10) and a second rib (12) is arranged on the second wall region (30), wherein the first rib (11) and the second rib (11) each project by a height H out of the first wall region (10) and, respectively, the second wall region (30) of the recess (7), wherein the height H is such that a width B of the projecting element (50) is somewhat larger than a remaining opening dimension C of the recess (7) of the receiving element (51), **characterized in that** at least one of the wall regions (10, 30) is formed by a limb (8) and a slot (6) is arranged on an outer side (16) of the limb (8), elastic deformation of the limb without great expenditure of force when the plug element is inserted into the housing part being possible owing to the said slot.

2. Controller according to one of the preceding claims, **characterized in that** the first rib (11) is arranged offset in relation to the second rib (12) normal to the base region (9) of the recess (7).

3. Controller according to either of the preceding claims, **characterized in that** the sensor is a rate of rotation sensor and/or an acceleration sensor.

4. Controller according to one of the preceding claims, **characterized in that** the ribs (11, 12) have a blade-like edge (14).

5. Controller according to one of the preceding claims, **characterized in that** a plurality of ribs (11, 12) are arranged parallel to one another on each wall region (10, 30) of the recess (7).

6. Controller according to one of the preceding claims, **characterized in that** the ribs (11, 12) run parallel to the base region (9) of the recess (7).

7. Controller according to one of the preceding claims, **characterized in that** a plurality of mechanical connections (5) are provided between the plug element (4) and the housing part (20, 21).

8. Controller according to one of the preceding claims, **characterized in that** each of the housing parts (20, 21) is connected to the plug element (4) by means of a mechanical connection (5).

## Revendications

1. Contrôleur, comprenant :
- un boîtier (2) ayant une première partie de boîtier (20) et une deuxième partie de boîtier (21),
- un circuit imprimé (3) disposé dans le boîtier (2),
- un élément connecteur (4) muni d'une pluralité de contacts (40) qui sont reliés à la fois mécaniquement et électriquement avec le circuit imprimé (3) et
- un capteur sensible aux oscillations,
- l'élément connecteur (4) étant relié à demeure à l'une des parties de boîtier (20, 21) au moyen d'une liaison mécanique (5),
- la liaison mécanique (5) possédant un élément en saillie (50) et un élément d'accueil (51) muni d'une cavité (7) destinée à accueillir l'élément en saillie (50),
- la cavité (7) possédant une zone de base (9), une première zone de paroi (10) et une deuxième zone de paroi (30) et
- une première nervure (11) étant disposée sur la première zone de paroi (10) et une deuxième nervure (12) sur la deuxième zone de paroi (30), la première nervure (11) et la deuxième nervure (11) dépassant respectivement de la cavité (7) d'une hauteur H hors de la première zone de paroi (10) ou de la deuxième zone de paroi (30), la hauteur H étant dimensionnée de telle sorte qu'une largeur B de l'élément en saillie (50) est légèrement plus grande qu'une cote d'ouverture restante C de la cavité (7) de l'élément d'accueil (51),
**caractérisé en ce qu'**au moins l'une des zones de paroi (10, 30) est formée par un montant (8) et sur un côté extérieur (16) du montant (8) est disposée une fente (6) par laquelle est rendue possible une déformation élastique de la branche lors de l'insertion de l'élément connecteur dans la partie de boîtier sans déploiement d'énergie important.

2. Contrôleur selon l'une des revendications précédentes, **caractérisé en ce que** la première nervure (11) est disposée normale par rapport à la zone de base (9) de la cavité (7), décalée par rapport à la deuxième nervure (12).

3. Contrôleur selon l'une des revendications précédentes, **caractérisé en ce que** le capteur est un capteur de vitesse de rotation et/ou un capteur d'accélération.

4. Contrôleur selon l'une des revendications précédentes, **caractérisé en ce que** les nervures (11, 12) possèdent un bord (14) en forme de lame.

5. Contrôleur selon l'une des revendications précédentes, **caractérisé en ce que** plusieurs nervures (11, 12) sont respectivement disposées parallèlement les unes aux autres sur chaque zone de paroi (10, 30) de la cavité (7).

6. Contrôleur selon l'une des revendications précédentes, **caractérisé en ce que** les nervures (11, 12) s'étendent parallèlement à la zone de base (9) de la cavité (7).

7. Contrôleur selon l'une des revendications précédentes, **caractérisé en ce que** plusieurs liaisons mécaniques (5) se trouvent entre l'élément connecteur (4) et la partie de boîtier (20, 21).

8. Contrôleur selon l'une des revendications précédentes, **caractérisé en ce que** chacune des parties de boîtier (20, 21) est reliée à l'élément connecteur (4) au moyen d'une liaison mécanique (5).
